(19) Europäisches Patentamt
European Patent Office
Office européen des brevets

(11) **EP 4 120 362 A1**

(12) **EUROPEAN PATENT APPLICATION**

(43) Date of publication:
**18.01.2023 Bulletin 2023/03**

(21) Application number: **21186132.3**

(22) Date of filing: **16.07.2021**

(51) International Patent Classification (IPC):
***H01L 29/51*** (2006.01)   ***H01L 29/739*** (2006.01)
***H01L 29/78*** (2006.01)

(52) Cooperative Patent Classification (CPC):
**H01L 29/7813; H01L 29/0878; H01L 29/512;**
**H01L 29/66734; H01L 29/7397; H01L 29/7802;**
H01L 29/7395

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Hitachi Energy Switzerland AG**
**5400 Baden (CH)**

(72) Inventors:
• **GUPTA, Gaurav**
  **5600 Lenzburg (CH)**
• **DE-MICHIELIS, Luca**
  **5000 Aarau (CH)**
• **VITALE, Wolfgang Amadeus**
  **5000 Aarau (CH)**

(74) Representative: **Epping - Hermann - Fischer**
**Patentanwaltsgesellschaft mbH**
**Schloßschmidstraße 5**
**80639 München (DE)**

(54) **POWER SEMICONDUCTOR DEVICE**

(57)     In at least one embodiment, the power semiconductor device (1) comprises:
- a semiconductor body (2) having a source region (21) of a first conductivity type and a well region (22) of a second conductivity type different from the first conductivity type, and the well region (22) comprises a channel region (220) starting directly at the source region (21), and

- a gate insulator (4) directly between the semiconductor body (2) and a gate electrode (31),
wherein the gate insulator (4) has a non-uniform gate dielectric constant profile along the channel region (220), such that a relative dielectric constant ($\varepsilon_{OX}$) of the gate insulator (4) is lowest in a first section (61) of the channel region (220) remote from the source region (21).

FIG 2

**Description**

Document US 6 225 669 B1 refers to a non-uniform gate/dielectric filed effect transistor.

Document US 6 503 786 B2 refers to a power MOS device with an asymmetrical channel structure for enhanced linear operation capability.

Embodiments of the disclosure relate to a power semiconductor device that shows improved electrical behavior.

This object is achieved, inter alia, by a power semiconductor device as defined in claim 1. Exemplary further developments constitute the subject-matter of the dependent claims.

In at least one embodiment, the power semiconductor device comprises:

- a semiconductor body having a source region of a first conductivity type and a well region of a second conductivity type different from the first conductivity type, and the well region comprises a channel region starting directly at the source region, and
- a gate insulator directly between the semiconductor body and a gate electrode,

wherein the gate insulator has a non-uniform gate dielectric constant profile along the channel region, such that a relative dielectric constant of the gate insulator is lowest in a first section of the channel region remote from the source region.

For example, the gate insulator is of at least two different materials having different relative dielectric constants, and the material with the smaller relative dielectric constant is located, or is predominantly located, in the first section.

Hence, it can be achieved that a threshold voltage $V_{th}$ is highest in a first section of the channel region remote from the source region.

The gate electrode is insulated from the semiconductor body by the gate insulator.

For example, the at least one source region is in direct contact with the assigned gate insulator and/or is directly at the assigned channel region. The first conductivity type is, for example, n-conductive and, thus, the at least one source region is n-doped.

The at least one well region and consequently the at least one channel region are of the second conductivity type different from the first conductivity type. The second conductivity type is, for example, p-conductive and, thus, the at least one channel region is p-doped. It is possible that a maximum doping concentration of the at least one well region and/or of the at least one channel region is less than a maximum doping concentration of the at least one source region.

According to at least one embodiment, the semiconductor body further comprises a drift region which may be of the first conductivity type, too. For example, the drift region is in direct contact with the gate insulator and/or is directly at the channel region. The drift region may be located between the channel region and a drain region or a collector region of the semiconductor body, for example, in a direction perpendicular to the top side of the semiconductor body. For example, the optional trench may terminate in the drift region.

As an option, the semiconductor body can comprise an enhancement layer. For example, the enhancement layer is located directly between the well region and the drift region and may have a higher maximum doping concentration than the drift region. The enhancement layer can also be of the first conductivity type.

According to at least one embodiment, the power semiconductor device is a metal-insulator-semiconductor field-effect transistor, MISFET, a metal-oxide-semiconductor field-effect transistor, MOSFET, or an insulated-gate bipolar transistor, IGBT or a reverse-conducting insulated-gate bipolar transistor, RC-IGBT.

According to at least one embodiment, the well region extends from the top side of the semiconductor body to the drift region. The channel region is part of the well region and may have the same doping concentration. During operation, the electrons flow in the channel region from the source region to the drift region along the gate insulator. The channel region has a thickness in a direction perpendicular to an interface between the gate insulator and the well region, for example, in a nanometer range, exemplarily 1 nm to 50 nm.

For example, the semiconductor body is of silicon, Si for short. However, the semiconductor body can alternatively be of a wide-bandgap semiconductor material like SiC, $Ga_2O_3$ or GaN.

For example, a difference of the relative dielectric constant along the channel region is at least 2.0 or is at least 3.0 or is at least 3.5. Alternatively or additionally, said difference is at most 50 or is at most 25. When comparing the respective relative dielectric constants, text book values for the respective materials at room temperature, that is, 300 K, and at a frequency of a varying electric field of at most 1 kHz may be used. Here and in the following, the term 'along the channel region' may refer to a direction of a current flow in the channel region in the intended use of the power semiconductor device.

The gate insulator is made of any combination of insulating materials, which may be oxides. For example, the gate insulator may include at least one or at least two of the following materials: $SiO_2$, $Si_3N_4$, $Al_2O_3$, $Y_2O_3$, $ZrO_2$, $HfO_2$, $La_2O_3$, $Ta_2O_5$, $TiO_2$. Hence, the gate insulator may also be referred to as gate oxide.

For example, the gate insulator includes a high-k material. A high-k material is a material having a relative dielectric constant larger than that of silicon oxide which is about 3.9. Further, the gate insulator may include a low-k material having a relative dielectric constant smaller than that of silicon oxide, that is, smaller than 3.9. For example, the gate insulator includes a high-k material as well as a low-k material.

According to at least one embodiment, the power semiconductor device is a power device. For example, the power semiconductor device is configured for a maximum voltage of at least 0.2 kV or of at least 0.6 kV or of at least 1.2 kV.

The power semiconductor device is, for example, for a power module in a vehicle to convert direct current from a battery or a fuel cell to alternating current for an electric motor, for example, in hybrid vehicles or plug-in electric vehicles. Moreover, the power semiconductor device can be a fuse, for example, in a vehicle like a car.

For simplification, in the following only one channel region and assigned components are mentioned. If there is a plurality of channel regions and assigned components, the features described below may apply to only one, to a plurality or to all of the channel regions and assigned components.

According to at least one embodiment, the gate insulator comprises a first material in the first section and a second material in a second section next to the source region. The first material has a smaller relative dielectric constant than the second material.

It is possible that the gate insulator consists of the first section and the second section. Otherwise, there can be at least one additional section, like a middle section, located between the first section and the second section, seen along the channel region. If there is at least one additional section, there can be at least one additional material having a relative dielectric constant that is different from the relative dielectric constants of the first material and of the second material.

According to at least one embodiment, a length of the first section is at least 5% or is at least 10% or is at least 15% of an overall length of the channel region along the gate insulator. Alternatively or additionally, said length is at most 40% or at most 30% or at most 25% of said overall length. The same may apply to the at least one additional section, if present.

According to at least one embodiment, the gate insulator has a uniform thickness profile along the channel region. In other words, a thickness of the gate insulator is constant all along the channel region.

According to at least one embodiment, the gate insulator has a non-uniform gate insulator thickness profile along the channel region. In other words, a thickness of the gate insulator varies along the channel region. Said thickness variation may be continuous or non-continuous, that is, stepped. For example, along the channel region, the gate insulator is thickest in the first section, and consequently may be thinnest in the second section.

According to at least one embodiment, the channel region has a non-uniform channel doping profile along the gate insulator. For example, a doping concentration $N_A$ in the channel region is largest in the first section and consequently may be smallest in the second section.

According to at least one embodiment, the gate electrode has a non-uniform gate electrode work function profile along the channel region, such that a threshold voltage of the gate electrode is highest in the first section. Hence, a work function $\Phi_m$ of the gate electrode in the first section remote from the source region is largest for n-channel devices and smallest for p-channel devices.

According to at least one embodiment, a work function difference of the gate electrode along the channel region is at least 0.7 eV or is at least 1.0 eV or is at least 1.1 eV. This applies, for example, when the gate electrode is based on poly-silicon. If metals like Li, Zn, Hf for a low work function, or metals like Pt, Pd or Au for a high work function are also considered, the work function difference may be at least 1.3 eV or at least 1.4 eV. For example, the work function difference is at most 2.0 eV or at most 1.5 eV.

For example, the gate electrode comprises a first gate material in the first section and a second gate material in the second section. The first gate material has a higher work function $\Phi_m$ than the second gate material for n-channel devices, and vice versa for p-channel devices.

According to at least one embodiment, the thickness of the gate insulator varies significantly along the channel region. This means, for example, that a minimum thickness of the gate insulator is at most 70% or is at most 50% of a maximum thickness of the gate insulator. In this respect, only the gate insulator along the channel region may be relevant.

According to at least one embodiment, along the gate insulator, a minimum doping concentration of the channel region is at most 50% or is at most 20% or is at most 10% of a maximum doping concentration of the channel region.

According to at least one embodiment, there is the non-uniform gate dielectric constant profile as well as at least one of the non-uniform gate insulator thickness profile, the non-uniform channel doping profile, and the non-uniform gate electrode work function profile. Hence, the relative dielectric constant of the gate insulator as well as the work function $\Phi_m$ of the gate electrode, the thickness of the gate insulator and the doping concentration $N_A$ in the channel region may vary along the channel region.

According to at least one embodiment, at least one of the non-uniform gate dielectric constant profile, the non-uniform gate insulator thickness profile, the non-uniform channel doping profile and the non-uniform gate electrode work function profile run in a continuous, stepless manner. Thus, the at least one respective profile may be represented by a differentiable function.

According to at least one embodiment, at least one of the non-uniform gate dielectric constant profile, the non-uniform gate insulator thickness profile, the non-uniform channel doping profile and the non-uniform gate electrode work function profile run in a stepped manner. Hence, the at least one respective profile comprises one or a plurality of steps and may not be represented by a differentiable function.

Any combination of stepped and continuous profiles can be used. For example, it is possible that the stepped non-uniform gate dielectric constant profile is combined with at least one of the stepped non-uniform gate insulator thickness profile, the continuous non-uniform channel doping profiles and the stepped non-uniform gate electrode work function profile.

According to at least one embodiment, the non-uniform gate dielectric constant profile and at least one of the non-uniform gate electrode work function profile, the non-uniform gate insulator thickness profile and the non-uniform channel doping profile run in the same manner. For example, the at least one step in the non-uniform gate dielectric constant profile and the at least one step in at least one of the non-uniform gate electrode work function profile, the non-uniform gate insulator thickness profile and the non-uniform channel doping profile are at a same position along the channel region.

According to at least one embodiment, the gate electrode is partially or completely arranged in at least one trench formed in the semiconductor body. The at least one trench and, thus, the assigned gate electrode extends through the well region into the drift region, for example, in a direction away from a top side of the semiconductor body. Consequently, the gate insulator is located partially or completely in the assigned trench, too. Hence, the power semiconductor device could be a trench-based device.

Otherwise, the gate electrode and the gate insulator are applied on the top side of the semiconductor body. Thus, the top side may be a planar face.

According to at least one embodiment, the power semiconductor device is configured so that both a saturation current and a short-circuit current are decreased, for example, while a collector-emitter saturation voltage $V_{ce\text{-}sat}$, and consequently on-state losses, may remain unaffected. This may be true because of the non-uniform gate dielectric constant profile, optionally supported by at least one of the non-uniform gate electrode work function profile, the non-uniform gate insulator thickness profile and the non-uniform channel doping profile, and compared with an analogously set-up reference semiconductor device but having a uniform gate dielectric constant profile, and optionally at least one of a uniform gate electrode work function profile, a uniform gate insulator thickness profile and a uniform channel doping profile along a gate insulator.

A power semiconductor device is explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:

Figure 1    is a schematic sectional view of a reference semiconductor device,

Figure 2    is a schematic sectional view of an exemplary embodiment of a power semiconductor device described herein,

Figure 3    is a top view of the power semiconductor device of Figure 2,

Figure 4    is a schematic diagram of the non-uniform gate dielectric constant profile of the power semiconductor device of Figures 2 and 3,

Figures 5 to 8    are schematic representations of electric data of power semiconductor devices described herein and of a reference semiconductor device, and

Figures 9 to 13    are schematic sectional views of exemplary embodiments of power semiconductor devices described herein.

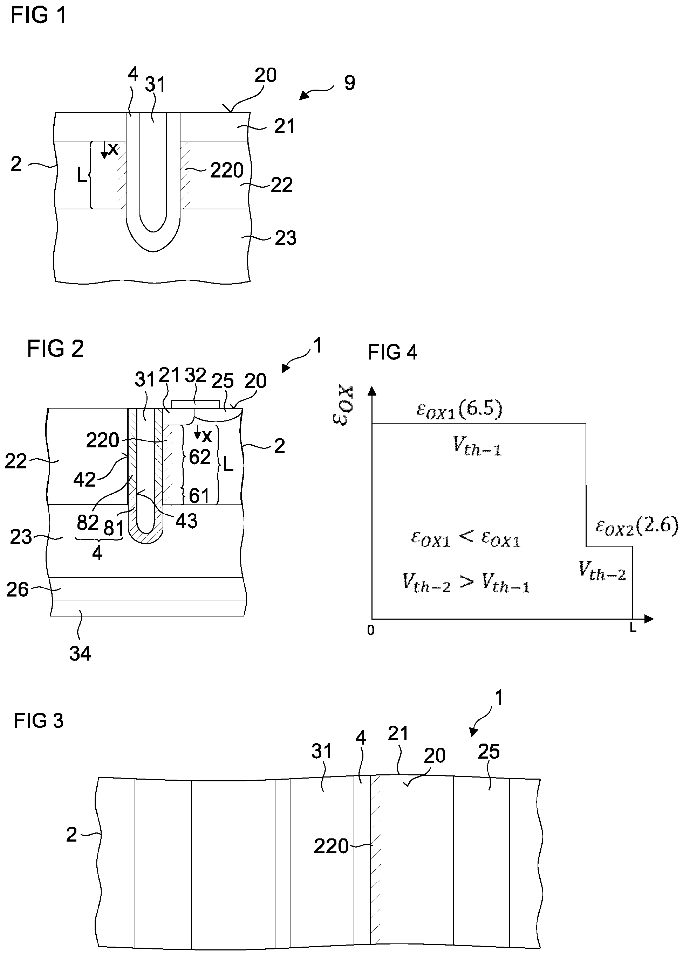

Figure 1 illustrates a reference semiconductor device 9 that corresponds to exemplary embodiments of power semiconductor devices 1 described herein except for a gate dielectric constant profile of a gate insulator 4 in a channel region 220 included in a well region 22. Like the power semiconductor devices 1, the reference semiconductor device 9 comprises a semiconductor body 2 which is, for example, of Si.

The semiconductor body 2 also comprises a source region 21 at a top side 20 of the semiconductor body 2. A trench passes both through the well region 22 and through the source region 21. The source region 21 is of a first conductivity type, like n-conducting, and the well region 22, and consequently the channel region 220 included by the well region 22, is of a second, different conductivity type, like p-conducting. In the trench, there is a gate electrode 31 that is separated from the semiconductor body 2 by means of the electrically insulating gate insulator 4. The trench and, hence, the gate electrode 31 end in a drift region 23 of the semiconductor body 2. The drift region 23 is of the first conductivity type, too.

In the reference semiconductor device 9, the gate insulator 4 is of only one material and has consequently constant relative dielectric constant $\varepsilon_{ox}$ all along the channel region 220, at areas of the gate insulator 4 facing the well region 22. That is, along a length direction x of the channel region 220 away from the source region 21 and towards the drift region 23, there is a uniform gate dielectric constant profile.

For example, next to the gate insulator 4 where the source region 21 and the channel region 220 are in direct contact, x = 0. For example, next to the gate insulator 4 where the channel region 220 and the drift region 23 are in direct contact, x = L. That is, L corresponds to a channel length of the channel region 220. It is noted that a shape of the channel region 220 is drawn only very schematically.

For example, x runs perpendicular to the top side 20 of the semiconductor layer body 2. Hence, the length L may correspond to a distance between the source region 21 and the drift region 23 directly at the gate insulator 4. Hence, the length L may be defined as the length of the second conductivity type layer between the layers of the first conductivity type, that is, the source region 21 and the drift region 23. As an option, the drift region 23 may comprise an enhancement layer of higher doping concentration attached to the well region 22 and a layer of lower doping concentration towards the backside of the device, not illustrated. x may be regarded as a current direction in the intended use of the reference semiconductor devices 9.

According to the exemplary embodiment of the power semiconductor device 1 as illustrated in Figures 2 and 3, the gate insulator 4 comprises a first material 81 and a second material 82. Along the length direction x, the first material 81 directly follows on the second material 82. Consequently, the gate insulator 4 has a non-uniform gate dielectric constant profile along the channel region 220.

A relative dielectric constant of the first material 81 is smaller than a relative dielectric constant of the second material 82. Thus, in a first section 61 remote from the source region 21, there is a minimum in the non-uniform gate dielectric constant profile. The rest of the channel region 220 is referred to as a second section 62. Within the first section 61 and also within the second section 62, respectively, the relative dielectric constant does not vary.

Thus, along the channel region 220 the gate insulator 4 may consist of the second section 62 and the first section 61 having the second material 82 and the first material 81, respectively. In a direction perpendicular to the length direction x, it is possible that the gate insulator 4 comprises only one material, that is, either the first material 81 or the second material 82.

The gate insulator 4 can be of constant thickness all along the channel region 220. For example, an inward side 43 of the gate insulator 4 facing the gate electrode 31 and/or an outward side 42 of the gate insulator 4 facing the semiconductor body 2 can be of planar fashion throughout the channel region 22. For example, seen in cross-section, the inward side 43 and/or the outward side 42 may appear as a straight line. Hence, along the channel region 220 the inward side 43 and/or the outward side 42 may be free of any steps.

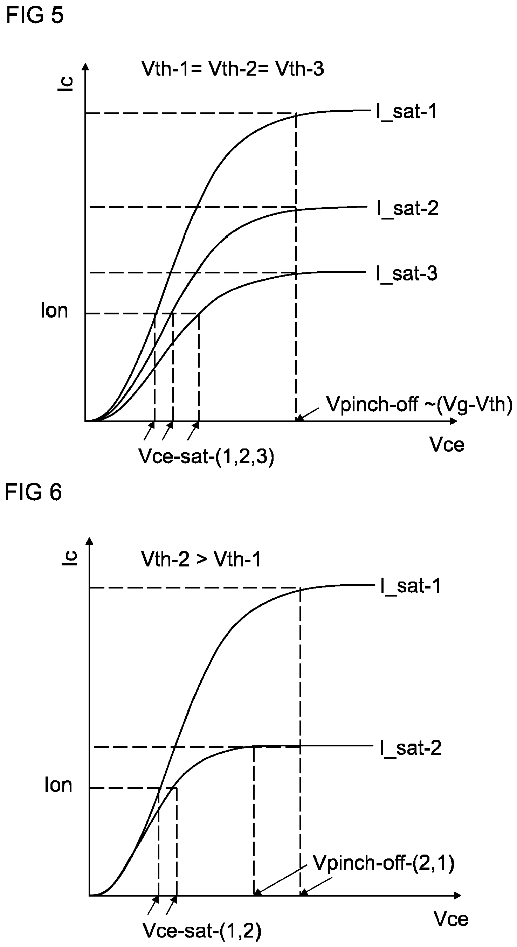

For example, the first material 81 is a low-k material having a relative dielectric constant $\varepsilon_{ox2}$ of 2.6 and the second material 82 is a high-k material having a relative dielectric constant $\varepsilon_{ox1}$ of 6.5, see Figure 4. A thickness of the gate insulator 4 is, for example, 100 nm all along the channel region 220. For example, the low-k material is silica-based, silsesquioxane (SSQ)-based or polymer-based, and the high-k material may be an oxide like $HfO_2$ or $ZrO_2$. Because of the lower dielectric constant in the first section 61, in the first section 61 the threshold voltage $V_{th-1}$ is lower than the threshold voltage $V_{th-2}$ in the second section 62. The influence on the threshold voltage $V_{th}$ along the channel region 220 is discussed in more detail below in connection with Figures 5 to 8.

As on option, to electrically contact the channel region 220, there can be at least one plug 25 at the top side 20 of the semiconductor body 2. The plug 25 may have a different thickness than the well region 22 so that the plug 25 can extend deeper or shallower into the semiconductor body 2 than the well region 22. Further, the thicknesses of the source region 21 and of the plug 25 can be the same or can be different.

Both the source region 21 and the at least one plug 25, or the well region 22, may be electrically connected by means of the at least one source electrode 32 which is located at the top side 20, for example. Exemplarily, the plug 25 has a higher maximum doping concentration than the well region 22 or the channel region 220. The depth of the plug may be lower, deeper or the same as of the well region 22 and the channel region 220.

For example, the power semiconductor device 1 is an insulated-gate bipolar transistor, IGBT for short. Hence, at as side of the drift region 23 remote from the well region 22, there is a collector region 26 which is of the second conductivity type, too. At the collector region 26, there is a collector electrode 34. Additionally, there can be a buffer region of the first conductivity type between the drift region 23 and the collector region 26. The doping concentration of such a buffer region can be higher than that of the drift region 23.

Seen in top view of the top side 20, the trench accommodating the gate electrode 31 and the gate insulator 4 may be of extended fashion. The source region 21, the at least one plug 25 as well as the channel region 220 may be arranged symmetrically on both sides of the trench, see Figure 3.

For example, maximum doping concentrations of the source regions 21, the collector region 26 (or instead of a drain region 24 in case of the device being a MISFET or a MOSFET) and the at least one plug 25 are at least $1 \times 10^{18}$ cm$^{-3}$ or at least $5 \times 10^{18}$ cm$^{-3}$ or at least $1 \times 10^{19}$ cm$^{-3}$ and/or at most $5 \times 10^{20}$ cm$^{-3}$ or at most $2 \times 10^{20}$ cm$^{-3}$ or at most $1 \times 10^{20}$ cm$^{-3}$. Further, a maximum doping concentration of the well region 22 and, thus, of the channel region 220 may be at least $5 \times 10^{16}$ cm$^{-3}$ or at least $1 \times 10^{17}$ cm$^{-3}$ and/or at most $5 \times 10^{19}$ cm$^{-3}$ or at most $5 \times 10^{18}$ cm$^{-3}$.

Depending on the voltage class of the power semiconductor device 1, a maximum doping concentration of the drift region 23 may be at least $1 \times 10^{11}$ cm$^{-3}$ or at least $1 \times 10^{12}$ cm$^{-3}$ or at least $1 \times 10^{13}$ cm$^{-3}$ and/or at most $1 \times 10^{17}$ cm$^{-3}$ or at most $5 \times 10^{16}$ cm$^{-3}$ or at most $1 \times 10^{16}$ cm$^{-3}$.

For example, a thickness of the gate insulator 4 is between 50 nm and 250 nm or between 80 nm and 150 nm.

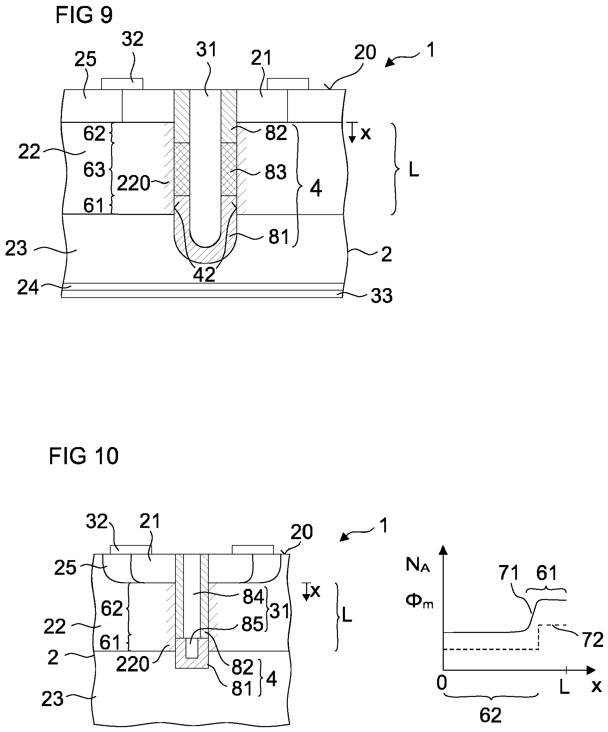

In Figures 2 and 3, the source region 21 and the at least one plug 25 are located along only one side of the gate electrode 31 so that there is a channel region 220 only along one outward side 42 of the gate insulator 4. However, the source region 21 as well as the at least one plug 25 can also be located along two sides of the gate electrode 31, compare, for example, Figure 9, or all around the gate electrode 31, when seen in top view.

Otherwise, the same as to Figure 1 may also apply to Figures 2 to 4.

The concept behind the gate insulator 4 having the non-uniform gate dielectric constant profile is explained in the following in some detail.

For a power semiconductor device 1, exemplarily for low frequency applications, it may be desirable to have on-state losses as low as possible in order to minimize the total electrical losses. Further, from a device reliability point of view, it may be advantageous to have a low short circuit current. Thus, a power semiconductor device 1 with minimized on-state losses and improved short circuit capability may be desired.

However, some means to lower an on-state voltage drop $V_{ce-sat}$, for example, by reducing the channel length L or increasing a channel width W, often result in an undesired higher saturation current $I_{sat}$, as illustrated schematically using output characteristics $I_c$ vs. $V_{ce}$, see Figure 5. The higher $I_{sat}$ is directly related to a higher short circuit current $I_{sc}$, adversely affecting the short circuit capability of the power semiconductor device 1. On the other hand, raising the threshold voltage $V_{th}$ of the power semiconductor device 1 in order to lower $I_{sat}$, for example, by increasing a channel doping concentration, results in higher $V_{ce-sat}$ as illustrated in Figure 6. Thus, Figures 5 and 6 are schematics of typical output characteristics of an IGBT with a uniform threshold voltage profile along the whole channel region 220, in Figure 5 for a same $V_{th}$ and different channel resistance, and in Figure 6 for different threshold voltages $V_{th}$.

Other techniques to reduce the short-circuit current such as:

a) increasing the channel length L,
b) reducing an anode injection efficiency, by reducing an anode implant dose,
c) reducing a channel width, by decreasing a source coverage along the trench, and
d) reducing the channel width, by increasing a cell pitch,

also undesirably result in higher on-state losses. Moreover, techniques such as d) can also adversely affect the breakdown capability of the power semiconductor device 1. Reducing gate biasing in order to reduce short-circuit current may also not be desirable as it leads to unstable dynamic behavior and moreover it is mainly defined by the application requirements.

Thus, there is a trade-off between minimizing the on-state losses and decreasing the short circuit current in a conventional MISFET or IGBT device. For an application requiring improved short circuit capability, it may be desirable to be able to decrease the short circuit current $I_{sc}$ without affecting $V_{ce-sat}$.

With the power semiconductor device 1 described herein, the trade-off between on-state losses and short circuit current is improved by improving the latter without adversely affecting the former. Differently from other approaches, the described design features a non-uniform threshold voltage profile along the channel region 220 next to the gate insulator 4 to lower down the saturation current for a given $V_{ce-sat}$.

The proposed non-uniform $V_{th}$ in the power semiconductor device 1 described herein is achieved by implementing the non-uniform gate dielectric constant profile of the gate insulator 4 along the channel region 220. In addition, the described concept is applicable to any MOS device in general such as power-MOSFET or IGBT or reverse-conducting-IGBT and is even compatible with both planar and trench architectures.

With the power semiconductor device 1 described herein, an improved MISFET, MOSFET, IGBT or RC-IGBT device with an enhanced short circuit capability is introduced without a detrimental effect on the on-state losses. The improved design also relaxes the design constraints of the IGBT or RC-IGBT, enabling the possibility to independently explore the other methods mentioned above to minimize the on-state losses which are normally limited by the short circuit capability of the respective device.

In the following, some theoretical background to the idea of the semiconductor device 1 described herein is presented.

For a reference long channel MOS device, it is known that a channel pinch-off at high $V_{ce}$ is responsible for the current saturation in the output characteristics, which ultimately determines the short circuit current. The channel pinch-off voltage $V_{pinch-off}$ is determined by the threshold voltage $V_{th}$. Exemplarily, the channel starts pinching-off near its drain end, at x = L where L is the channel length, when the applied bias $V_{ce}$ exceeds the pinch-off voltage $V_{pinch-off} \approx (V_g - V_{th})$, where $V_g$ is the applied gate voltage. At such applied $V_{ce}$, the voltage drop perpendicular to the channel is less than $V_{th}$ and therefore the channel cannot sustain any longer near the drain end.

However, for a more detailed understanding of the device, it should be considered that the channel pinch-off, however, is more of a local phenomenon, taking place specifically near the drain end of the channel. Therefore, more correctly, it is the local threshold voltage, $V_{th}$ (x), which determines the pinch-off point and, thus, the saturation current. This implies that it is possible to lower the $V_{pinch-off}$ by locally increasing $V_{th}$ (L) at the channel end, that is, in the first section 61 near the drift region 23.

Further, in order to keep the overall channel resistance and thereby $V_{ce\text{-}sat}$ unaffected, $V_{th}$ (x) can be decreased in the rest of the channel.

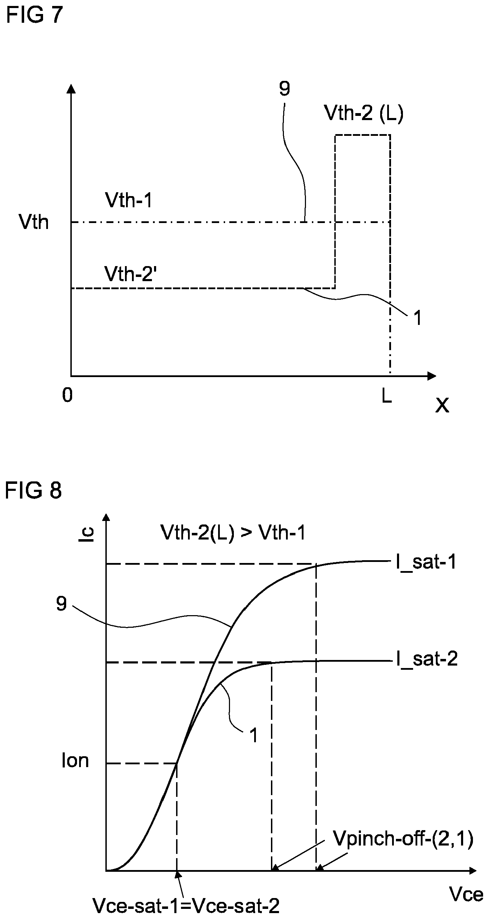

This is illustrated schematically in Figure 7 where the curve referring to the reference semiconductor device 9 comprises a uniform threshold voltage $V_{th\text{-}1}$ profile along the whole channel. The curve for the power semiconductor device 1 on the other hand consists of a non-uniform $V_{th}$ profile along the channel, where $V_{th}$ is locally raised near the channel end, that is, in the first section 61, such that $V_{th\text{-}2}(L) > V_{th\text{-}1}$ in order to lower the pinch-off point, while $V_{th\text{-}2}' < V_{th\text{-}1}$ in the rest of the channel to keep the overall channel resistance the same. In this way, a saturation current and thereby a short circuit current can be significantly reduced without affecting the on-state losses as illustrated in the schematic output in Figure 8. Local $V_{th}$ variation thus holds the key for improved short circuit capability of a MISFET or MOSFET or an IGBT device.

$V_{th}$ of the channel is a function of various other MOS cell design parameters as indicated in below equation:

$$V_{th} = V_{fb} + 2\Phi_B + \frac{\sqrt{qN_A 2\varepsilon_S 2\Phi_B}}{C_{ox}}$$

where $V_{th}$ is the threshold voltage, $V_{fb}$ is the flatband voltage, $V_{fb} = (\Phi_m - \Phi_s)$ where $\Phi_m$ and $\Phi_s$ are the gate electrode work function and the semiconductor work function, respectively. $N_A$ is the channel body doping, $\varepsilon_s$ is the permittivity of the semiconductor, $C_{ox}$ is the gate insulator capacitance, and $\phi_B$ is the semiconductor surface potential and:

$$\Phi_B = kt \ln \frac{N_A}{n_i}$$

where k is the Boltzmann constant, T is the temperature and $n_i$ is the intrinsic carrier concentration of the semiconductor.

Therefore, the required non-uniform $V_{th}$ profile across the channel with relatively higher $V_{th}$ in the first section 61 can be achieved by introducing a non-uniformity in one or in any combination of the following MOS design parameters:

    1. channel doping profile, $N_A$ (x),
    2. gate oxide thickness, Tox (x),
    3. gate dielectric, $\varepsilon_{ox}$ (y), as detailed herein, and/or
    4. gate metal work function, $\phi_m$ (x), since $V_{fb} = (\Phi_m - \Phi_s)$.

In the following, the focus is on the gate dielectric constant profile variation, but said dielectric variation can of course be combined with a varying gate insulator thickness, a varying gate electrode work function and/or a varying channel doping concentration.

It is noted that more than one combination of dielectric constants or even gradient in dielectric constant, with lower $\varepsilon_{ox}$ near the channel end, can achieve the same objectives. Moreover, even the physical length of higher and lower $\varepsilon_{ox}$ regions can be adjusted to suit the purpose and to overcome fabrication challenges.

Hence, non-uniformity in the $V_{th}$ profile along the channel region 220 can be introduced by adopting different gate dielectric materials 81, 82 along the channel region 220. This may be equivalent to an approach where a gate oxide thickness $t_{ox}$ is varied instead since both are related to $V_{th}$ by $C_{ox}$, see above, which is proportional to the ratio of $\varepsilon_{ox}/t_{ox}$. Therefore, the same effect which is observed by increasing, or decreasing, the gate oxide thickness $t_{ox}$ can also be obtained by decreasing, or increasing, the relative dielectric constant $\varepsilon_{ox}$ by the same ratio as illustrated in Figure 4. For example, for a uniform gate oxide thickness $t_{ox}$ of 100 nm, a thickness variation from 60 nm in the second section 62 to 150 nm in the first section 61, assuming a constant relative dielectric constant $\varepsilon_{ox}$, can be effectively replicated if $\varepsilon_{ox}$ in the second section 62 at the start of the channel region is raised to 6.5 while $\varepsilon_{ox}$ in the end of the channel region 220, that is, in the first section 61, is set to 2.6.

According to Figure 9, on both sides of the gate electrode 31 there is the source region 21 and the at least one plug 25 so that the channel region 220 is also along the two outward sides 42. Further, as an option it is shown in Figure 9 that the gate insulator 4 is composed of the first material 81, the second material 82 and a third material 83 located in a middle section 63 between the first section 61 and the second section 62, seen along the channel region 220. A relative dielectric constant of the third material 83 is between the relative dielectric constants of the first material 81 and of the second material 82.

Although in Figure 9 there are the three materials 81, 82, 83 in the gate insulator 4, it is possible that the gate insulator 4 includes more than three different materials.

Moreover, it is illustrated that the power semiconductor device 1 of Figure 9 is not an IGBT, but a MISFET or MOSFET. Consequently, the power semiconductor device 1 comprises a drain region 24 instead of the collector region 26. Hence, at as side of the drift region 23 remote from the well region 22, there is the drain region 24 which is of the first conductivity type, too, but, for example, with a maximum doping concentration higher than in the drift region 23. At the drain region 24, there is a drain electrode 33.

Of course, all the gate insulator designs of the IGBT power semiconductor devices 1 can apply for the MOSFET and MISFET power semiconductor device 1, and vice versa.

Otherwise, the same as to Figures 2 to 8 may also apply to Figure 9, and vice versa.

In Figure 10 it is illustrated that the trench in which the gate insulator 4 and the gate electrode 31 are accommodated, does not need to have a round ending in the drift region 23, but can also be of rectangular or trapezoidal shape when seen in cross-section.

Moreover, in Figure 10 it is illustrated that there is not only the non-uniform gate dielectric constant profile because of the at least two different materials 81, 82, but also a non-uniform gate insulator thickness profile. That is, the thickness of the gate insulator 4 varies along the channel region 220. For example, a thickness of the first material 81 in the first section 61 exceeds a thickness of the second material 82 in the second section 62, or vice versa. For example, a thickness difference between the first material 81 and the second material 82 is at least 20% or at least 40% of a maximum thickness of the gate insulator 4 along the channel region 220. If there is only the non-uniform gate insulator thickness profile and a uniform gate dielectric constant profile, the gate insulator 4 can be of a single material. For example, a thickness of the gate insulator 4 in the second section 62 is between 50 nm and 100 nm inclusive and/or a thickness of the gate insulator 4 in the first section 61 is between 100 nm and 240 nm inclusive. However, other than illustrated in Figure 10, the thickness of the gate insulator 4 in the first section 61 can alternatively be smaller than in the second section 62, and a maximum thickness can instead be present in the second section 62.

Additionally or alternatively to the non-uniform gate insulator thickness profile, there can be a non-uniform gate electrode work function profile 72 of the gate electrode 31. Hence, the gate electrode 31 can include a first gate material 84 next to the source region 21 and a second gate material 85 next to the drain region 23. The gate materials 84, 85 may change where the materials 81, 82 of the gate insulator 4 change. Hence, the work function $\Phi_m$ of the gate electrode 31 in the first section 61 remote from the source region 21 is largest for n-channel devices and smallest for the p-channel devices.

For example, the second gate material 85 is p$^+$-doped poly-silicon having a work function $\Phi_m$ of about 5.22 eV. For example, the first gate material 84 is n$^+$-doped poly-silicon having a work function $\Phi_m$ of about 4.1 eV. Although based on silicon, these first gate materials 84 and second materials 85 may be referred to as different gate electrode metals.

Accordingly, there is a step in the non-uniform gate electrode work function profile 72 at the interface between the first section 61 and the second section 62, see the insert in Figure 10.

Additionally or alternatively to the non-uniform gate insulator thickness profile and/or the non-uniform gate electrode work function profile 72, there can be a non-uniform channel doping profile 71. That is, a doping concentration $N_A$ in the well region 22 varies along the channel region 220.

For example, a maximum doping concentration present in the non-uniform channel doping profile 71 is at least $5 \times 10^{16}$ cm$^{-3}$ and at most $5 \times 10^{19}$ cm$^{-3}$ and/or a minimum doping concentration present in the non-uniform channel doping profile 71 is at most $2 \times 10^{17}$ cm$^{-3}$ or at most $1 \times 10^{17}$ cm$^{-3}$. The maximum doping concentration may be present in the first section 61, and the minimum doping concentration may be present in the second section 62. Throughout the first section 61 and the second section 62, respectively, the doping concentration $N_A$ may be constant so that the doping concentration $N_A$ varies in a stepped manner, for example. However, a step in the doping concentration $N_A$ does not need to exactly follow a theta function or unit step function, but there can be of sinusoidal shape, see the insert in Figure 10. Said step may be at the location where the materials 81, 82 of the gate insulator 4 change.

Such at least one of the non-uniform gate electrode work function profile 72, the non-uniform gate insulator thickness profile and the non-uniform channel doping profile 71 can be present analogously in all the other exemplary embodiments, too.

Otherwise, the same as to Figures 2 to 9 may also apply to Figure 10, and vice versa.

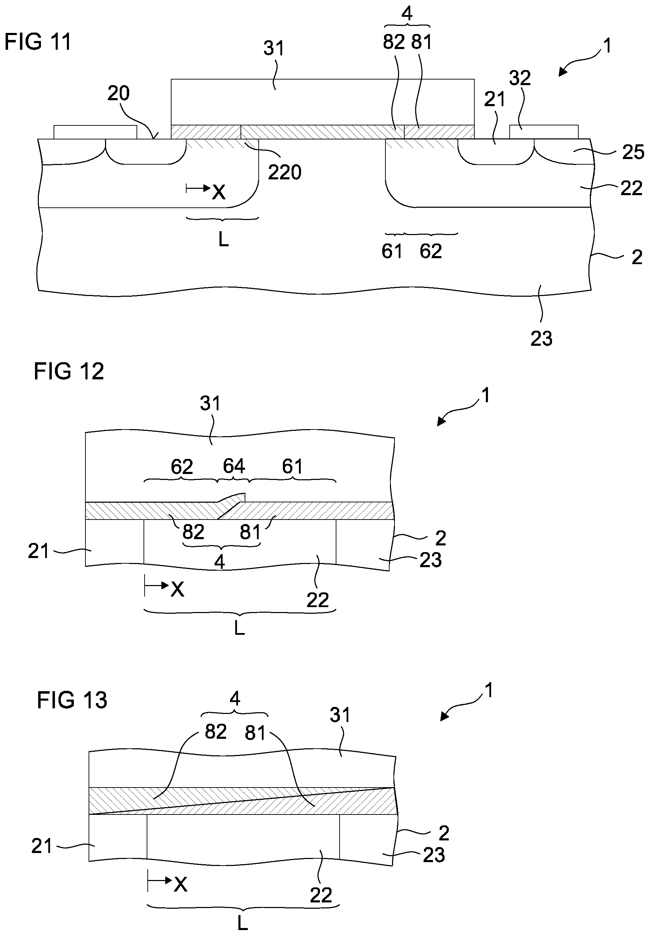

According to Figure 11, the power semiconductor device 1 is of a planar design and not of a trench design like, for example, the power semiconductor device 1 of Figures 2 and 3. Hence, the top side 20 is planar, and the gate insulator 4 and the gate electrode 31 are applied onto the top side 20. Consequently, the length direction x runs in parallel with the top side 20 from the source region 21 to the drift region 23, and not like in the other exemplary embodiments perpendicular to the top side 20. The power semiconductor device 1 of Figure 11 could be any MISFET device or any IGBT device.

In Figure 11, the well region 22 protrudes from the source region 21 in a lateral direction, that is, in parallel with the top side 20, and extends below the gate insulator 4. Also the source region 21 may extend below the gate insulator 4, but less far. A change from the second material 82 to the first material 81 occurs at the top side 20 at the well region 22. The channel region 220 consequently runs along the top side 20.

Otherwise, the same as to Figures 2 to 10 may also apply to Figure 11, and vice versa.

According to Figure 12, there is a step in the non-uniform gate dielectric constant profile, too, like in Figure 2, but the first material 81 and the second material 82 do not have a plane interface perpendicular to the length direction x. Instead, the interface may have a ramp-like shape due to a manufacturing process. Hence, a transitional section 64 is formed. In the transitional section 64, it is possible that the materials 81, 82 are stacked one above the other so that there is, for example, an unintentional minor thickness variation of the gate insulator 4. For example, such a thickness variation amounts to at most 50% or to at most 10% of a maximum thickness of the gate insulator 4 along the channel region 220.

Compared to the overall channel length L, a length of the transitional section 64 along the length direction x is small and amounts, for example, to at most 2% or to at most 5% of the overall channel length L. The same may apply to all other exemplary embodiments. Such a transitional section 62, or a plurality of such transitional sections, could also be present in all other exemplary embodiments at the interface between the different materials 81, 82, 83 of the gate insulator 4. Such at least one transitional section 64 may also be present in the non-uniform work gate electrode function profile 72, in the non-uniform gate insulator thickness profile and/or in the non-uniform channel doping profile 71, if present.

Otherwise, the same as to Figures 2 to 11 may also apply to Figure 12, and vice versa.

In Figure 13 it is illustrated that the second material 82 is applied on the first material 81. An overall thickness of the gate insulator 4 may remain constant all along the channel region 220. Thus, the thicknesses of the materials 81, 82 may change linearly along the channel region 220 so that an effective relative dielectric constant of the gate insulator 4 may change continuously, for example, linearly, along the channel region 220.

Otherwise, the same as to Figures 2 to 12 may also apply to Figure 13, and vice versa.

The components shown in the figures follow, unless indicated otherwise, exemplarily in the specified sequence directly one on top of the other. Components which are not in contact in the figures are exemplarily spaced apart from one another. If lines are drawn parallel to one another, the corresponding surfaces may be oriented in parallel with one another. Likewise, unless indicated otherwise, the positions of the drawn components relative to one another are correctly reproduced in the figures.

The power semiconductor device described here is not restricted by the description on the basis of the exemplary embodiments. Rather, the power semiconductor device encompasses any new feature and also any combination of features, which includes any combination of features in the patent claims, even if this feature or this combination itself is not explicitly specified in the patent claims or exemplary embodiments.

Reference Signs

| | |
|---|---|
| 1 | power semiconductor device |
| 2 | semiconductor body |
| 20 | top side |
| 21 | source region |
| 22 | channel region |
| 23 | drift region |
| 24 | drain region |
| 25 | plug |
| 26 | collector region |
| 31 | gate electrode |
| 32 | source electrode |
| 33 | drain electrode |
| 34 | collector electrode |
| 4 | gate insulator |
| 42 | outward side of the gate insulator |
| 43 | inward side of the gate insulator |
| 61 | first section |
| 62 | second section |
| 63 | middle section |
| 64 | transitional section |
| 71 | non-uniform channel doping profile |
| 72 | non-uniform gate electrode work function profile |
| 81 | first material |
| 82 | second material |
| 83 | third material |
| 84 | first gate material |
| 85 | second gate material |
| $\varepsilon_{ox}$ | relative dielectric constant |
| L | length of the channel region along the gate insulator |
| $V_{th}$ | threshold voltage |
| x | length direction along the channel region |

**Claims**

1. A power semiconductor device (1) comprising:

   - a semiconductor body (2) having a source region (21) of a first conductivity type and a well region (22) of a second conductivity type different from the first conductivity type, and the well region (22) comprises a channel region (220) starting directly at the source region (21), and
   - a gate insulator (4) directly between the semiconductor body (2) and a gate electrode (31),

   wherein the gate insulator (4) has a non-uniform gate dielectric constant profile along the channel region (220), such that a relative dielectric constant ($\varepsilon_{ox}$) of the gate insulator (4) is lowest in a first section (61) of the channel region (220) remote from the source region (21).

2. The power semiconductor device (1) according to the preceding claim, wherein a difference of the relative dielectric constant ($\varepsilon_{ox}$) along the channel region (220) is at least 2.0.

3. The power semiconductor device (1) according to any one of the preceding claims, wherein at least one of the following applies:

   - a length of the first section (61) is at least 10% and at most 40% of an overall length (L) of the channel region (220) along the gate insulator (4), and
   - a thickness of the gate insulator (4) is constant all along the channel region (220).

4. The power semiconductor device (1) according to claim 1 or 2,
wherein a thickness of the gate insulator (4) varies along the channel region (220).

5. The power semiconductor device (1) according to any one of the preceding claims,
wherein the non-uniform gate dielectric constant profile of the gate insulator (4) along the channel region (220) changes in a stepped manner so that there is at least one step (43) in the relative dielectric constant ($\varepsilon_{ox}$) of the gate insulator (4) along the channel region (220).

6. The power semiconductor device (1) according to the preceding claim,
wherein the gate insulator (4) has a second section (62) which is located next to the source region (21), seen along the channel region (220),
wherein the relative dielectric constant ($\varepsilon_{ox}$) of the gate insulator (4) has a specific first value in the first section (61) and a specific second value in the second section (62).

7. The power semiconductor device (1) according to any one of the preceding claims,
wherein, perpendicular to the channel region (220), the relative dielectric constant ($\varepsilon_{ox}$) varies within the gate insulator (4).

8. The power semiconductor device (1) according to any one of the preceding claims,
wherein,
wherein an inward side (43) of the gate insulator (4) facing the gate electrode (31) is of planar fashion along the channel region (220).

9. The power semiconductor device (1) according to any one of the preceding claims,
wherein an outward side (42) of the gate insulator (4) facing the semiconductor body (2) is of planar fashion along the channel region (220).

10. The power semiconductor device (1) according to any one of the preceding claims,
wherein at least one of the following is true:

- the gate electrode (31) has a non-uniform gate electrode work function profile (71) along the channel region (220), such that a threshold voltage ($V_{th}$) of the gate electrode (31) is highest in the first section (61), or
- the channel region (220) has a non-uniform channel doping profile (72) along the gate insulator (4), so that a doping concentration $N_A$ in the channel region (220) is largest in the first section (61).

11. The power semiconductor device (1) according to the preceding claim,
wherein a work function difference of the gate electrode (31) along the channel region (220) is at least 1.0 eV.

12. The power semiconductor device (1) according to any one of claims 10 and 11,
wherein, along the gate insulator (4), a minimum doping concentration of the channel region (220) is at most 50% of a maximum doping concentration of the channel region (220).

13. The power semiconductor device (1) according to any one of the preceding claims,
wherein the gate electrode (31) is at least partially arranged in a trench formed in the semiconductor body (2) and through the well region (22).

14. The power semiconductor device (1) according to any one of claims 1 to 12,
wherein the gate electrode (31) and the gate insulator (4) are arranged on a planar top side (20) of the semiconductor body (2).

15. The power semiconductor device (1) according to any one of the preceding claims, wherein

- the source region (21) is in direct contact with the gate insulator (4) and the channel region (220),
- the semiconductor body (2) further comprises a drift region (23) which is of the first conductivity type and which is in direct contact with the gate insulator (4) and is located directly at the channel region (220), and
- the power semiconductor device (1) is a metal-insulator-semiconductor field-effect transistor, MISFET, a metal-oxide-semiconductor field-effect transistor, MOSFET, an insulated-gate bipolar transistor, IGBT, or a reverse-conducting insulated-gate bipolar transistor, RC-IGBT.

FIG 1

FIG 2

FIG 4

$\varepsilon_{OX1}(6.5)$

$V_{th-1}$

$\varepsilon_{OX1} < \varepsilon_{OX1}$

$V_{th-2} > V_{th-1}$

$\varepsilon_{OX2}(2.6)$

$V_{th-2}$

FIG 3

FIG 5

Vth-1= Vth-2= Vth-3

Ic

I_sat-1

I_sat-2

I_sat-3

Ion

Vpinch-off ~(Vg-Vth)

Vce

Vce-sat-(1,2,3)

FIG 6

Vth-2 > Vth-1

Ic

I_sat-1

I_sat-2

Ion

Vpinch-off-(2,1)

Vce

Vce-sat-(1,2)

FIG 7

FIG 8

FIG 9

FIG 10

FIG 11

FIG 12

FIG 13

Europäisches
Patentamt

European
Patent Office

Office européen
des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/064550 A1 (SUGIMOTO MASAHIRO [JP] ET AL) 3 March 2016 (2016-03-03) | 1-6, 8-10, 13-15 | INV. H01L29/51 H01L29/739 |
| Y | * paragraph [0016] – paragraph [0042]; figures 1, 2 * <br> * paragraph [0048] – paragraph [0068]; figures 4-7 * <br> * paragraph [0075] * | 7,11,12 | H01L29/78 |
| Y | CN 109 087 951 A (SHENZHEN NANSHUO MINGTAI TECH CO LTD) 25 December 2018 (2018-12-25) | 7 | |
| A | * abstract * <br> * associated text; figures 1-3 * | 1-6,8-15 | |
| Y | US 2015/214362 A1 (OH TAE-KYUNG [KR]) 30 July 2015 (2015-07-30) <br> * paragraph [0045] – paragraph [0046]; figure 2A * | 11 | |
| Y | US 2016/104794 A1 (TAKEUCHI YUICHI [JP] ET AL) 14 April 2016 (2016-04-14) <br> * paragraph [0028]; figure 1 * | 12 | TECHNICAL FIELDS SEARCHED (IPC) |
| A | J. ROBERTSON: "High dielectric constant oxides", THE EUROPEAN PHYSICAL JOURNAL APPLIED PHYSICS, vol. 28, no. 3, 2 December 2004 (2004-12-02), pages 265-291, XP055054404, ISSN: 1286-0042, DOI: 10.1051/epjap:2004206 <br> * table 2 * | 1-15 | H01L |

The present search report has been drawn up for all claims

| Place of search | Date of completion of the search | Examiner |
|---|---|---|
| Munich | 9 January 2022 | Lantier, Roberta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 18 6132

This annex lists the patent family members relating to the patent documents cited in  the above-mentioned European search report.
The members are as contained in the European Patent Office EDP file on
The European Patent Office is in no way liable for these particulars which are merely given for the purpose of information.

09-01-2022

| Patent document cited in search report | | Publication date | Patent family member(s) | | Publication date |
|---|---|---|---|---|---|
| US 2016064550 | A1 | 03-03-2016 | JP | 2016054181 A | 14-04-2016 |
| | | | US | 2016064550 A1 | 03-03-2016 |
| CN 109087951 | A | 25-12-2018 | NONE | | |
| US 2015214362 | A1 | 30-07-2015 | KR | 20150090669 A | 06-08-2015 |
| | | | US | 2015214362 A1 | 30-07-2015 |
| US 2016104794 | A1 | 14-04-2016 | CN | 105264667 A | 20-01-2016 |
| | | | JP | 6048317 B2 | 21-12-2016 |
| | | | JP | 2014236189 A | 15-12-2014 |
| | | | US | 2016104794 A1 | 14-04-2016 |
| | | | WO | 2014196164 A1 | 11-12-2014 |

EPO FORM P0459

For more details about this annex : see Official Journal of the European Patent Office, No. 12/82

**EP 4 120 362 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6225669 B1
- US 6503786 B2